# EUROPÄISCHE PATENTSCHRIFT

(11) **EP 2 944 710 B1**
(45) Veröffentlichungstag und Bekanntmachung des Hinweises auf die Patenterteilung: **04.07.2018**
(21) Anmeldenummer: 14167941.5
(22) Anmeldetag: 12.05.2014
(51) Int. Cl.: C21D 8/04, C25D 5/36, C21D 1/673, C23C 14/30, C23C 14/56, C23C 14/58, C22C 38/02, C22C 38/04, C22C 38/00, C22C 38/06, C22C 38/16, C25D 5/10, C25D 3/56, C25D 5/50, B32B 15/01, C22C 38/14, C23C 14/16

(54) **Verfahren zur Herstellung eines mit einer metallischen, korrosionsschützenden Beschichtung versehenen warmumgeformten Stahlbauteils aus presshärtbarem Stahl**
Method for producing a hot-formed steel component made from press-hardenable steel provided with a metallic, corrosion-protective coating
Procédé de fabrication d'un composant en acier durissiable sous pression formé à chaud et muni d'un revêtement métallique anti-corrosion

(43) Veröffentlichungstag der Anmeldung: 18.11.2015
(73) Patentinhaber: ThyssenKrupp Steel Europe AG, 47166 Duisburg (DE); thyssenkrupp AG, 45143 Essen (DE)
(72) Erfinder: Schuhmacher, Bernd, Dr., 44227 Dortmund (DE); Schwerdt, Christian, 47058 Duisburg (DE); Schrooten, Axel, 44137 Dortmund (DE); Bause, Ralf, 44143 Dortmund (DE)
(74) Vertreter: Cohausz & Florack

(56) Entgegenhaltungen:
- DE-B3-102012 110 972
- JP-A- S6 452 059
- JP-A- H01 129 962
- JP-A- H01 139 755
- JP-A- H01 142 076
- JP-A- H05 179 424
- JP-A- S56 133 488
- JP-A- S57 114 692
- JP-A- 2007 056 307
- US-A- 5 002 837

## Beschreibung

Die Erfindung betrifft ein Verfahren zur Herstellung eines mit einer metallischen, korrosionsschützenden Beschichtung versehenen warmumgeformten Stahlbauteils aus presshärtbarem Stahl.

Ein seit vielen Jahren bekanntes und bewährtes Verfahren zum Schutz von Stahlsubstraten vor Korrosion ist das Schmelztauchbeschichten von Feinblech, insbesondere bandförmigem Stahlfeinblech in einem Zink oder eine Zinklegierung enthaltenden Schmelzbad. Die Schichtdicke des Zinküberzuges wird dabei üblicherweise mittels Abstreifdüsen eingestellt, die oberhalb des Schmelzbades angeordnet und auf den im Wesentlichen vertikal aus dem Schmelzbad herauslaufenden Teil des Stahlbandes gerichtet sind. Dieses Beschichtungsverfahren wird auch Feuerverzinkung genannt.

Eine ebenfalls seit vielen Jahren bekannte Variante von feuerverzinktem Feinblech ist das sogenannte "Galvannealed". Diese Variante wird erzeugt, indem das Stahlband nach den Abstreifdüsen in einem Ofen wärmebehandelt wird, wobei Eisen aus dem Grundmaterial in die Zinkschicht diffundiert und letztere in eine Zink-Eisen-Legierungsschicht umwandelt.

In der EP 1 143 029 B1 ist ein Verfahren zur Realisierung eines Werkstücks mit sehr hohen mechanischen Eigenschaften beschrieben, bei dem das Werkstück durch Warmtiefziehen ausgehend von einem Blechzuschnitt umgeformt wird. Der Blechzuschnitt wird aus einem Stahlblechband des Typs "Galvannealed" zugeschnitten. Vor dem Warmtiefziehen des Blechzuschnitts wird an dessen Oberfläche eine intermetallische Legierungsverbindung realisiert, die einen Schutz gegen Korrosion und gegen eine Entkohlung des Stahls sicherstellen soll. Hierzu wird das Stahlblechband, das mit Zink oder einer Legierung auf der Basis von Zink beschichtet ist, einer Wärmebehandlung unterzogen, wobei das beschichtete Stahlblechband eine Temperaturerhöhung auf über 700°C erfährt.

An Stahlfeinblech des Typs "Galvannealed" wurden in der Praxis jedoch häufig sichtbare Risse und Poren in dem metallischen Korrosionsschutzüberzug festgestellt, welche auch noch nach der Lackierung des Feinbleches sichtbar sind und somit hohen Ansprüchen an die Lackoberfläche mitunter nicht genügen.

Die DE 10 2012 110 972 B3 offenbart ein Verfahren zum Herstellen eines Erzeugnisses aus flexibel gewalztem Bandmaterial aus Stahlblech, wobei das Bandmaterial elektrolytisch mit einem metallischen Beschichtungsmaterial, das zumindest Zink und Eisen enthält, beschichtet wird und anschließend eine Wärmebehandlung bei Temperaturen über 300°C und unterhalb einer Soliduslinie des Beschichtungsmaterials durchläuft. In einer Ausführungsform wird das Bandmaterial vor dem elektrolytischen Beschichten mit einer Zwischenschicht aus Nickel, Aluminium oder Mangan beschichtet.

Die JP H01 129962 A offenbart ein Verfahren zur Herstellung eines beschichteten, korrosionsgeschützten Stahlbandes für Automobilaußenteile, bei dem durch Gasphasenabscheidung eine Zink-Eisen-Schicht erhalten wird. Diese Schicht weist in Richtung des Substrats einen zunehmenden Zinkgehalt auf.

Davon ausgehend lag der Erfindung die Aufgabe zugrunde, ein Verfahren anzugeben, mit dem sich eine korrosionsschützende metallische Beschichtung speziell für gemäß dem Prozess der Warmumformung herzustellende Stahlbauteile realisieren lässt. Die Beschichtung soll dabei Zink enthalten, um eine kathodische Schutzwirkung zu erreichen. Außerdem soll die Beschichtung so beschaffen sein, dass (anders als bei der Zink- und Galvannealed-Beschichtung) bereits nach einer relativ kurzen Aufheizzeit die Gefahr einer Zinkpenetration entlang von Korngrenzen und damit die Gefahr eingeschränkter mechanischer Stabilität des Bauteils nicht mehr gegeben sind.

Gelöst wird diese Aufgabe durch ein Verfahren mit den in Anspruch 1 angegebenen Merkmalen. Vorteilhafte und bevorzugte Ausgestaltungen des erfindungsgemäßen Verfahrens sind in den Unteransprüchen angegeben.

Das erfindungsgemäße Verfahren ist dadurch gekennzeichnet, dass zur Bildung der metallischen, korrosionsschützenden Beschichtung eine eisenbasierte Legierung, die Zn als weiteren Hauptbestandteil enthält und aus
50 - 80 Gew.-% Fe, vorzugsweise 50 - 65 Gew.-% Fe,
0 - 30 Gew.-% Mg,
0 - 5 Gew.-% Al,
0 - 5 Gew.-% Ti,
0 - 10 Gew.-% Si,
0 - 10 Gew.-% Li,
0 - 10 Gew.-% Ca,
0 - 30 Gew.-% Mn,
Rest Zn und unvermeidbaren Verunreinigungen besteht, auf ein Stahlsubstrat aus presshärtbarem Stahl mittels physikalischer Gasphasenabscheidung oder einer Kombination aus physikalischer Gasphasenabscheidung und elektrolytischer Abscheidung auf das Stahlsubstrat appliziert wird, wobei Fe und Zn separat voneinander abgeschieden werden und sich die elektrolytische Abscheidung auf Zn bezieht, wobei eine Vorerwärmung des Stahlsubstrats vor dem Applizieren der eisenhaltigen Legierung oder eine thermische Nachverdichtung nach der Abscheidung von Fe und Zn zur ersten Legierungsbildung durchgeführt wird, wobei im Falle der Vorerwärmung das Stahlsubstrat während des Applizierens der eisenhaltigen Legierung eine Temperatur im Bereich von 250 - 350°C aufweist, und dass das mit der eisenbasierten Legierung beschichtete Stahlsubstrat einer Warmumformung unterzogen wird, um das Stahlbauteil zu erlangen.

In internen Versuchen wurde überraschend festgestellt, dass sich die erfindungsgemäß hergestellten metallischen Beschichtungen (Überzüge) auch nach der Warmumformung durch einen exzellenten Korrosionsschutz einschließlich kathodischer Schutzwirkung auszeichnen. Insbesondere wurde festgestellt, dass durch das erfindungsgemäße Verfahren Risse und Poren in der Beschichtung, wie sie bei einer Zink- und Galvannealed-Beschichtung typisch sind, vermieden werden.

Zudem wurde gefunden, dass das erfindungsgemäße Verfahren eine deutliche Reduzierung der Aufheizzeit (Haltezeit) während der Erwärmungsphase des Warmumformprozesses gestattet, ohne dass es anschließend an dem erfindungsgemäß beschichteten und warmumgeformten Stahlsubstrat zu einer Bildung von Rissen kommt. Die Reduzierung der Aufheizzeit (Haltezeit) bedeutet auch eine entsprechende Energieeinsparung bzw. ermöglicht eine Kapazitätserhöhung in Bezug auf vorhandene Warmumformanlagen. Des Weiteren führt das erfindungsgemäße Verfahren bzw. die Reduzierung der Aufheizzeit zu einer weitgehend Vermeidung einer Zunderbildung am Stahlsubstrat. Aufgrund der hohen Temperaturstabilität der Fe-Zn-Legierung werden auch Ablagerungen an Ofenbauteilen während der Erwärmungsphase des Warmumformprozesses vermieden.

Das erfindungsgemäße Verfahren ist dadurch gekennzeichnet, dass die eisenbasierte Legierung mittels physikalischer Gasphasenabscheidung (PVD-Verfahren) oder einer Kombination aus physikalischer Gasphasenabscheidung und elektrolytischer Abscheidung auf das Stahlsubstrat appliziert wird. Auf diese Weise lässt sich die korrosionsschützende Beschichtung aus der eisenbasierten Legierung sehr gleichförmig auf dem Stahlsubstrat (Feinblech) ausbilden. Mikroskopisch unterscheidet sich die so hergestellte korrosionsschützende metallische Beschichtung deutlich von einer Beschichtung, die sich aus einer zinkreichen Vorbeschichtung mit anschließender Glühung ergibt. Zur direkten Applikation der eisenbasierten Legierung auf das Stahlsubstrat (Feinblech) eignen sich bevorzugt speziell auf die Verdampfung von hochschmelzenden Metallen angepasste PVD-Verfahren mit hoher Auftragsrate, z.B. das Elektronenstrahlverdampfen.

Erfindungsgemäß wird die eisenbasierte Legierung durch das beanspruchte Verfahren auf das vor Korrosion zu schützende Stahlsubstrat (Feinblech) appliziert. Sie soll sich also nicht wie bei Feinblech vom Typ Zink bzw. "Galvannealed" erst während der Glühung im Wärmebehandlungsofen bzw. im Ofen einer Warmumformanlage durch Diffusion von Eisen ausbilden. Allerdings kann es aus verschiedenen Gründen von Vorteil sein, die eisenbasierte Legierung auf ein temperiertes Stahlsubstrat aufzubringen. Als besonders vorteilhaft hat sich eine Temperierung des Stahlsubstrats auf Temperaturen zwischen 250°C und 350°C herausgestellt. Das erfindungsgemäße Verfahren sieht daher vor, das Stahlsubstrat vor dem Applizieren der eisenbasierten Legierung zu erwärmen, wobei das Stahlsubstrat während des Applizierens der eisenbasierten Legierung eine Temperatur im Bereich von 250 - 350°C, vorzugsweise 280 - 320°C aufweist. Alternativ dazu kann das Stahlsubstrat mit der abgeschiedenen Beschichtung thermisch nachverdichtet werden. Eine vorteilhafte Ausgestaltung des erfindungsgemäßen Verfahrens sieht vor, dass die eisenbasierte Legierung in einer Weise auf das Stahlsubstrat appliziert wird, dass die aus der eisenbasierten Legierung gebildete Beschichtung eine Schichtdicke von größer 1 µm, vorzugsweise größer 2 µm aufweist. Beispielsweise weist die aus der eisenbasierten Legierung erfindungsgemäß hergestellte Beschichtung eine Schichtdicke im Bereich von 2 - 30 µm, insbesondere im Bereich von 5 - 20 µm auf. Hierdurch kann ein besonders zuverlässiger Korrosionsschutz erzielt werden.

Nach einer weiteren Ausgestaltung des erfindungsgemäßen Verfahrens kann die eisenbasierte Legierung optional 2 - 30 Gew.-% Mg und/oder 2 - 5 Gew.-% Al und/oder 2 - 5 Gew.-% Ti und/oder 2 - 10 Gew.-% Si und/oder 2 - 10 Gew.-% Li und/oder 2 - 10 Gew.-% Ca und/oder 2 - 30 Gew.-% Mn (Rest Zn) enthalten. Die genannten Legierungsbestandteile bremsen kontinuierliche Oxidations- und Diffusionsprozesse, wodurch der Erhalt einer kathodisch schützenden Phase in der pressgehärteten Beschichtung begünstigt wird.

Eine besonders vorteilhafte Ausgestaltung der korrosionsschützenden metallischen Beschichtung ergibt sich, wenn die eisenbasierte Legierung einen Fe-Gehalt im

Bereich von 50 - 65 Gew.-% und einen Mg-Gehalt im Bereich von 20 - 30 Gew.-%, Rest Zn aufweist. Bei einem Mg-Gehalt oberhalb von 20 Gew.-% zeigt sich auch bei einem Fe-Gehalt von über 50 Gew.-% eine signifikante kathodische Schutzwirkung. Eine bevorzugte Ausgestaltung des erfindungsgemäßen Verfahrens sieht daher vor, dass die eisenbasierte Legierung 20 - 30 Gew.-% Mg enthält.

Aluminium und/oder Titan können der eisenbasierten Legierung zugegeben werden, um den Schutz des Zinkgehaltes zu gewährleisten. Denn diese Elemente wirken einem Abdampfen des Zinkes während der Erwärmung bzw. Austenitisierung des warmumformenden Stahlsubstrats (Feinblechs) entgegen. Außer Magnesium können insbesondere auch Lithium und Calcium den kathodischen Korrosionsschutz verbessern.

Zur Erzielung gewichtsreduzierter Stahlbauteile mit sehr hoher mechanischer Festigkeit sieht eine weitere bevorzugte Ausgestaltung des erfindungsgemäßen Verfahrens vor, dass das durch Warmumformung erhaltene Stahlbauteil während der Warmumformung und/oder daran anschließend in einer Weise abgekühlt wird, dass das Stahlbauteil eine Abschreckhärtung erfährt.

Nachfolgend wird die Erfindung anhand von Ausführungsbeispielen näher erläutert. Es zeigen:
- Fig. 1: ein aus einem Galvannealed-Feinblech durch Warmtiefziehen erzeugtes Rundnäpfchen in einer perspektivischen Vorderansicht mit Rissen im Bereich der stärksten Verformung;
- Fig. 2: ein Abschnitt eines durch Warmtiefziehen erzeugten Rundnäpfchens mit dem Bereich der stärksten Verformung in einem senkrechten bzw. vertikalen Anschliff;
- Fig. 3: die Ergebnisse einer makroskopischen Rissbeurteilung anhand von Rundnäpfchen, die aus Galvannealed-Feinblech bzw. aus mit einer erfindungsgemäßen eisenbasierten Legierung beschichtetem Feinblech jeweils durch Warmtiefziehen bei verschiedenen Temperaturen und Haltezeiten (Aufheizzeiten) erzeugt wurden; und
- Fig. 4: eine Mikrorissauswertung anhand von Rundnäpfchen, die aus Galvannealed-Feinblech (GA) bzw. aus mit einer eisenbasierten Legierung erfindungsgemäß beschichtetem Feinblech (Fe-Bas.) jeweils durch Warmtiefziehen bei 880°C und verschiedenen Haltezeiten erzeugt wurden.

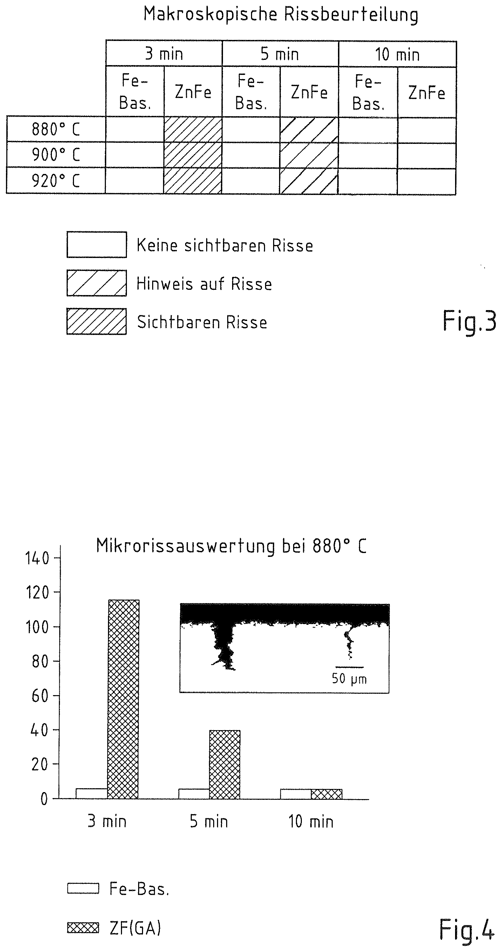

Den in Fig. 3 dargestellten Ergebnissen einer makroskopischen Rissbeurteilung sowie der in Fig. 4 dargestellten Mikrorissauswertung liegen Rundnäpfchen N zugrunde, die zum einen aus Galvannealed-Feinblech mit legierter Zn-Fe-Beschichtung (GA) und zum anderen erfindungsgemäß aus mit einer eisenbasierten Legierung (Fe-Bas.) beschichtetem Feinblech jeweils durch Warmtiefziehen erzeugt wurden.

Das Grundmaterial des verwendeten Feinblechs bestand jeweils aus presshärtbarem Stahl, z.B. Stahl des Typs 22MnB5. Die legierte Zn-Fe-Beschichtung des Galvannealed-Feinblechs enthielt ca. 11 Gew.-% Fe, ca. 0,3 Gew.-% Al und Rest Zink, während die im PVD-Verfahren mittels Elektronenstrahlverdampfens direkt applizierte Fe-Basislegierung (Fe-Bas.) ca. 51 Gew.-% Fe, ca. 22 Gew.-% Mg und ca. 27 Gew.-% Zn enthielt.

Die jeweiligen Blechzuschnitte wurden vor dem Warmtiefziehen erwärmt, und zwar auf ca. 880°C, 900°C bzw. 920°C, und dabei auf der jeweiligen besagten Temperatur für eine Dauer von 3 min, 5 min bzw. 10 min gehalten.

Die entsprechend aufgeheizten Blechzuschnitte wurden mittels einer einen Stempel und eine Matrize aufweisenden Presse in Rundnäpfchen N umgeformt.

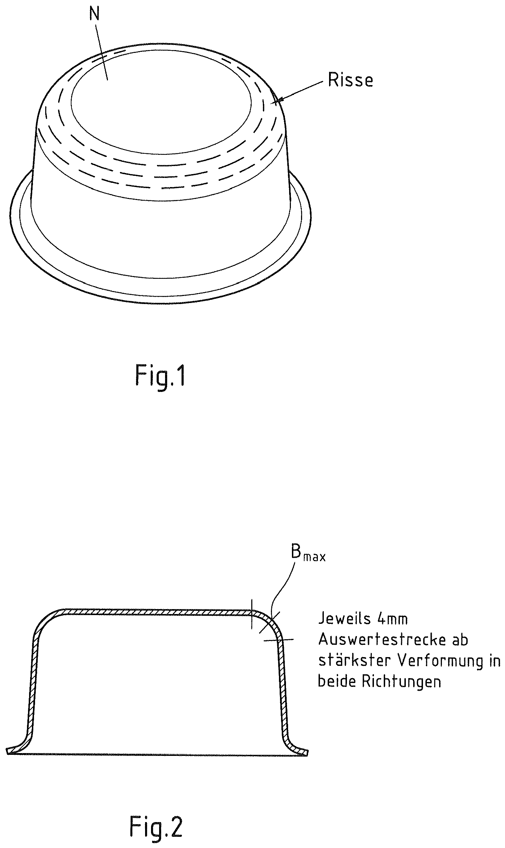

Die aus dem mit einer Haltezeit von 3 min aufgeheizten Galvannealed-Feinblech geformten Rundnäpfchen N wiesen jeweils in dem am stärksten umgeformten Bereich, d.h. im Übergangsbereich vom Boden in die umlaufende Mantelfläche des Rundnäpfchens sichtbare Risse auf (vgl. Fig. 1 und Fig. 3). Des Weiteren zeigten auch die aus dem 5 min lang aufgeheizten Galvannealed-Feinblech geformten Rundnäpfchen N in dem besagten Bereich einen Hinweis auf Risse (vgl. Fig. 3). Bei den aus dem 10 min lang aufgeheizten Galvannealed-Feinblech geformten Rundnäpfchen N konnten schließlich weder sichtbare Risse noch ein Hinweis auf Risse festgestellt werden. Demzufolge lässt sich eine Rissbildung bei der Warmumformung von Galvannealed-Feinblech nur durch relativ lange Haltezeiten reduzieren. Dagegen ließen sich an den Rundnäpfchen, die erfindungsgemäß aus dem mit der Fe-Basislegierung (Fe-Bas.) beschichteten Feinblech geformt wurden, bei den genannten drei Temperaturen sowie drei Haltezeiten keine Risse in dem am stärksten umgeformten Bereich feststellen (vgl. Fig. 3).

Für die Mikrorissauswertung wurden Rundnäpfchen, die zum einen aus dem Galvannealed-Feinblech und zum anderen aus dem mit der Fe-Basislegierung (Fe-Bas.) beschichteten Feinblech geformt wurden, welches jeweils auf etwa 880°C aufgeheizt und auf dieser Temperatur 3 min, 5 min bzw. 10 min gehalten wurde, vertikal zerschnitten und geschliffen, so dass sich im Übergangsbereich vom Boden des Rundnäpfchens in dessen umlaufende Mantelfläche ein senkrechter Anschliff ergab (vgl. Fig. 2). Die Stelle der stärksten Verformung ist in Fig. 2 mit Bmax bezeichnet. Der Anschliff wurde ab der Stelle der stärksten Verformung in beide Richtungen über eine Auswertestrecke von jeweils 4 mm untersucht. Dabei konnten an den Rundnäpfchen, die aus dem mit der Fe-Basislegierung (Fe-Bas.) beschichteten Feinblech geformt wurden, keine nennenswerten Risse festgestellt werden. Bei den Rundnäpfchen, die aus dem Galvannealed-Feinblech geformt wurden, konnten dagegen deutliche Risstiefen festgestellt werden. Bei einem Rundnäpfchen N aus dem Galvannealed-Feinblech, welches vor dem Warmtiefziehen 3 min auf einer Temperatur von 880°C gehalten wurde, wurde eine Risstiefe von ungefähr 120 µm festgestellt. Mit zunehmender Haltezeit verringerte sich die Risstiefe. So betrug die Risstiefe bei einem Rundnäpfchen N aus dem Galvannealed-Feinblech, welches vor dem Warmtiefziehen 5 min auf einer Temperatur von 880°C gehalten wurde, noch ungefähr 40 µm. Bei einem Rundnäpfchen aus dem Galvannealed-Feinblech, welches vor dem Warmtiefziehen 10 min auf einer Temperatur von 880°C gehalten wurde, konnten nennenswerte Risse nicht festgestellt werden.

Nachfolgend wird die Erfindung anhand der Ergebnisse von drei Versuchen weiter erläutert:

### Versuch 1:

Ein Grundwerkstoff, z.B. Stahlfeinblech des Typs 22MnB5, wird mittels PVD im kontinuierlichen Beschichtungsverfahren mit 50 Gew.-% Fe und 49 Gew.-% Zn, sowie 1 Gew.-% Ti beschichtet. Erreicht wird dies durch das simultane Abscheiden von Fe und Ti mittels eines Elektronenstrahlverdampfers und das Abscheiden von Zn in einem separaten Beschichtungsschritt mittels eines Jet-PVD. Aufgrund der unterschiedlichen Schmelz- und Siedepunkte von Fe und Zn ist ein simultanes Abscheiden beider Elemente schwierig. Es ergab sich eine Schichtdicke von ca. 8 µm. Diese Schicht wird anschließend in einem Durchlaufofen thermisch bei 380°C über eine Dauer von 25 Sekunden nachverdichtet. Die thermische Nachverdichtung dient der Haftverbesserung der Schichten sowie der ersten Legierungsbildung durch Feststoffdiffusion.

Das so im kontinuierlichen Bandbeschichtungsprozess erzeugte Material wurde anschließend, in Anlehnung an die Prozesse beim weiterverarbeitenden Kunden, zu Platinen geschnitten und einem Presshärteprozess zugeführt. Während der von 6 min auf 3 min verkürzten Aufheizphase im Labor-Presshärteofen stellte sich ein Überzug mit 55 Gew.-% Fe und 44 Gew.-% Zn sowie eine nur 1,5 µm dicke Ti- und Zinkoxidschicht ein.

Die durch das Presshärten erzeugten Stahlbauteile wiesen (im Unterschied zu Stahlbauteilen, die aus Feinblechen des Typs Z bzw. ZF (10 Gew.-% FE)) auch bei Umformgraden zwischen 20 und 30 % keine bis in das Stahlsubstrat reichen Risse auf. Der Restgehalt an metallischem Zink der Beschichtung ist hoch genug, um einen aktiven Korrosionsschutz zu gewährleisten.

### Versuch 2:

Ein Grundwerkstoff, z.B. Stahlfeinblech des Typs 22MnB5, wird mittels PVD im kontinuierlichen Beschichtungsverfahren mit 50 Gew.-% Fe und 45 Gew.-% Zn, sowie 5 Gew.-% Mg beschichtet. Erreicht wird dies durch das Abscheiden von Mg und Zn jeweils mittels JET-PVD, sowie das Applizieren von Fe auf ein vorzugsweise zuvor auf ca. 300°C erwärmtes Substrat in einem zweiten Beschichtungsschritt mittels Elektronenstrahlverdampfung. Die so insgesamt erhaltene Schichtdicke betrug ca. 8 µm.

Das so im kontinuierlichen Bandbeschichtungsprozess erzeugte Material wurde anschließend, in Anlehnung an die Prozesse beim weiterverarbeitenden Kunden, zu Platinen geschnitten und einem Presshärteprozess zugeführt. Während der von 6 min auf 3,5 min verkürzten Aufheizphase im Labor-Presshärteofen stellte sich ein Überzug mit 65 Gew.-% Fe und 32 Gew.-% Zn sowie einer 1 bis 2 µm dicken Magnesiumoxidschicht ein.

Das pressgehärtete Stahlbauteil wies keine tiefen Substratrisse auf, wie sie bei nicht temperaturstabilen Zinküberzügen nach der Warmumformung auftreten.

Der Überzug konnte problemlos gereinigt, phosphatiert und KTL-beschichtet werden. Auch die Eignung für das Widerstandspunktschweißen war gegeben.

Es wurde überraschenderweise auch festgestellt, dass der Korrosionsschutz demjenigen eines reinen, im Ausgangszustand 10 µm dicken Zinküberzugs nach indirekter Presshärtung ebenbürtig war.

### Versuch 3:

Auf einen Grundwerkstoff, z.B. Stahlfeinblech des Typs 22MnB5, wurde zuerst ein ca. 5 µm dicke Zn-Schicht elektrolytisch aufgebracht. Anschließend wurde im PVD-Verfahren mittels Elektronenstrahlverdampfens eine ca. 5-6 µm dicke Fe-Schicht appliziert. Über ein weiteres Target wurde simultan Al abgeschieden.

Die so erhaltene Schicht enthielt 50 Gew.-% Fe, 48 Gew.-% Zn und 2 Gew.-% Al. In einem Durchlaufofen wurde die Schicht anschließend thermisch bei 450°C und 2 min nachverdichtet. Dieser Behandlungsschritt dient der Haftverbesserung der Schichten sowie der ersten Legierungsbildung durch Feststoffdiffusion.

Das so im kontinuierlichen Bandbeschichtungsprozess erzeugte Material wurde anschließend, in Anlehnung an die Prozesse beim weiterverarbeitenden Kunden, zu Platinen geschnitten und einem Presshärteprozess zugeführt. Während der von 6 min auf 3,5 min verkürzten Aufheizphase im Labor-Presshärteofen stellte sich ein Überzug mit 65 Gew.-% Fe, 33 Gew.-% Zn und 2 Gew.-% Al sowie einer ca. 2 µm dicken Al- und Zinkoxidschicht ein.

Zudem wurde überraschenderweise festgestellt, dass sich die so hergestellten Stahlbauteile durch einen elektrochemisch nachweisebaren, aktiven Korrosionsschutz des Stahlsubstrats auszeichnen.

## Patentansprüche

1. Verfahren zur Herstellung eines mit einer metallischen, korrosionsschützenden Beschichtung versehenen warmumgeformten Stahlbauteils aus presshärtbarem Stahl, bei dem zur Bildung der Beschichtung eine eisenbasierte Legierung, die Zn als weiteren Hauptbestandteil enthält und aus
50 - 80 Gew.-% Fe, vorzugsweise 50 - 65 Gew.-% Fe,
0 - 30 Gew.-% Mg,
0 - 5 Gew.-% Al,
0 - 5 Gew.-% Ti,
0 - 10 Gew.-% Si,
0 - 10 Gew.-% Li,
0 - 10 Gew.-% Ca,
0 - 30 Gew.-% Mn,
Rest Zn und unvermeidbaren Verunreinigungen besteht, auf ein Stahlsubstrat aus presshärtbarem Stahl mittels physikalischer Gasphasenabscheidung oder einer Kombination aus physikalischer Gasphasenabscheidung und elektrolytischer Abscheidung auf das Stahlsubstrat appliziert wird,
wobei Fe und Zn separat voneinander abgeschieden werden und sich die elektrolytische Abscheidung auf Zn bezieht, wobei eine Vorerwärmung des Stahlsubstrats vor dem Applizieren der eisenbasierten Legierung oder eine thermische Nachverdichtung nach der Abscheidung von Fe und Zn zur ersten Legierungsbildung durchgeführt wird, wobei im Falle der Vorerwärmung das Stahlsubstrat während des Applizierens der eisenbasierten Legierung eine Temperatur im Bereich von 250 - 350°C aufweist, und bei dem das mit der eisenbasierten Legierung beschichtete Stahlsubstrat einer Warmumformung unterzogen wird, um das Stahlbauteil zu erlangen.

2. Verfahren nach Anspruch 1, **dadurch gekennzeichnet, dass** die eisenbasierte Legierung in einer Weise auf das Stahlsubstrat appliziert wird, dass die aus der eisenbasierten Legierung gebildete Beschichtung eine Schichtdicke von größer 1 µm, vorzugsweise größer 2 µm aufweist.

3. Verfahren nach einem der Ansprüche 1 bis 2, **dadurch gekennzeichnet, dass** die eisenbasierte Legierung
2 - 30 Gew.-% Mg und/oder
2 - 5 Gew.-% Al und/oder
2 - 5 Gew.-% Ti und/oder
2 - 10 Gew.-% Si und/oder
2 - 10 Gew.-% Li und/oder
2 - 10 Gew.-% Ca und/oder
2 - 30 Gew.-% Mn enthält.

4. Verfahren nach einem der Ansprüche 1 bis 3, **dadurch gekennzeichnet, dass** die eisenbasierte Legierung 20 - 30 Gew.-% Mg enthält.

5. Verfahren nach einem der Ansprüche 1 bis 4, **dadurch gekennzeichnet, dass** das durch Warmumformung erhaltene Stahlbauteil während der Warmumformung und/oder daran anschließend in einer Weise abgekühlt wird, dass das Stahlbauteil eine Abschreckhärtung erfährt.

## Claims

1. Method for producing a hot-formed steel component made from press-hardenable steel and provided with a metallic anticorrosion coating, wherein for forming the coating an iron-based alloy containing Zn as a further main component and consisting of
50 - 80% by weight Fe, preferably 50-65% by weight Fe,
0 - 30% by weight Mg,
0 - 5% by weight Al,
0 - 5% by weight Ti,
0 - 10% by weight Si,
0 - 10% by weight Li,
0 - 10% by weight Ca,
0 - 30% by weight Mn,
remainder Zn and unavoidable impurities, is applied on a steel substrate of press-hardenable steel by means of physical vapor deposition or a combination of physical vapor deposition and electrolytic deposition,
wherein Fe and Zn are deposited separately from each other and the electrolytic deposition refers to Zn, wherein preheating of the steel substrate before the application of the iron-based alloy or thermal sealing after the deposition of Fe and Zn is performed to form a first alloy, wherein in the case of preheating the steel substrate has a temperature in the range of 250-350°C during application of the iron-based alloy, and wherein the steel substrate coated with the iron-based alloy undergoes hot forming to obtain the steel component.

2. Method according to claim 1, **characterized in that** the iron-based alloy is applied to the steel substrate in such a way that the coating layer formed by the iron-based alloy has a thickness of more than 1 µm, preferably of more than 2 µm.

3. Method according to any one of claims 1 to 2, **characterized in that** the iron-based alloy contains
2 - 30% by weight Mg and/or
2 - 5% by weight Al and/or
2 - 5% by weight Ti and/or
2 - 10% by weight Si and/or
2 - 10% by weight Li and/or
2 - 10% by weight Ca and/or
2 - 30% by weight Mn.

4. Method according to any one of claims 1 to 3, **characterized in that** the iron-based alloy contains 20-30% by weight Mg.

5. Method according to any one of claims 1 to 4, **characterized in that** the steel component obtained by hot forming is cooled during hot forming and/or subsequently in such a way that the steel component is quench hardened.

## Revendications

1. Procédé de fabrication d'un composant en acier se composant d'un acier durcissable à la presse, ledit composant en acier étant formé à chaud et doté d'un revêtement métallique protégeant contre la corrosion, procédé dans lequel un alliage à base de fer, servant à la formation du revêtement, est appliqué sur un substrat en acier se composant d'acier durcissable à la presse, ladite application étant réalisée au moyen d'un dépôt physique en phase vapeur ou bien au moyen d'une combinaison d'un dépôt physique en phase vapeur et d'un dépôt électrolytique se produisant sur le substrat en acier, lequel alliage contient du Zn comme autre composant principal et se compose :
de 50 à 80 % en poids de Fe, de préférence de 50 à
65 % en poids de Fe,
de 0 à 30 % en poids de Mg,
de 0 à 5 % en poids d'Al,
de 0 à 5 % en poids de Ti,
de 0 à 10 % en poids de Si,
de 0 à 10 % en poids de Li,
de 0 à 10 % en poids de Ca,
de 0 à 30 % en poids de Mn,
d'une quantité résiduelle de Zn et se compose d'impuretés inévitables,
où le Fe et le Zn sont déposés séparément l'un de l'autre, et le dépôt électrolytique se rapporte à du Zn, où un préchauffage du substrat en acier est effectué avant l'application de l'alliage à base de fer, ou bien une postcompression thermique est effectuée après le dépôt de Fe et de Zn, ledit préchauffage ou ladite postcompression servant à la première formation de l'alliage, où, dans le cas du préchauffage, le substrat en acier, au cours de l'application de l'alliage à base de fer, présente une température se situant dans la plage de 250°C à 350°C, et procédé au cours duquel le substrat en acier recouvert de l'alliage à base de fer est soumis à un formage à chaud, pour obtenir le composant en acier.

2. Procédé selon la revendication 1, **caractérisé en ce que** l'alliage à base de fer est appliqué sur le substrat en acier, de manière telle que le revêtement formé par l'alliage à base de fer présente une épaisseur de couche supérieure à 1 µm, de préférence supérieure à 2 µm.

3. Procédé selon l'une des revendications 1 à 2, **caractérisé en ce que** l'alliage à base de fer contient :
de 2 à 30 % en poids de Mg et / ou
de 2 à 5 % en poids d'Al et / ou
de 2 à 5 % en poids de Ti et / ou
de 2 à 10 % en poids de Si et / ou
de 2 à 10 % en poids de Li et / ou
de 2 à 10 % en poids de Ca et / ou
de 2 à 30 % en poids de Mn.

4. Procédé selon l'une quelconque des revendications 1 à 3, **caractérisé en ce que** l'alliage à base de fer contient de 20 à 30 % en poids de Mg.

5. Procédé selon l'une quelconque des revendications 1 à 4, **caractérisé en ce que** le composant en acier obtenu par formage à chaud est refroidi au cours du formage à chaud et / ou à la suite dudit formage à chaud, de manière telle que le composant en acier subisse un durcissement par trempe.
